# EUROPEAN PATENT APPLICATION

(11) **EP 4 668 328 A1**
(43) Date of publication of application: **24.12.2025**
(21) Application number: 25182800.0
(22) Date of filing: 13.06.2025
(51) Int. Cl.: H01L 23/31, H01L 23/00, H01L 21/56, H01L 23/29

(54) **SIC-BASED ELECTRONIC DEVICE WITH ENHANCED ROBUSTNESS AND METHOD FOR MANUFACTURING THE ELECTRONIC DEVICE**

(30) Priority: 19.06.2024 IT 202400014080
(71) Applicant: STMicroelectronics International N.V., 1228 Plan-les-Ouates, Geneva (CH)
(72) Inventor: RASCUNÀ, Simone, 95129 CATANIA (IT)
(74) Representative: Studio Torta S.p.A.

(57) **Abstract**

Electronic device (50; 100), wherein a semiconductor body (53) of silicon carbide has a surface (53a) and an edge zone (55). An edge structure (52) extends above the edge zone (55) of the semiconductor body (53) and is formed by a metal layer (58); a first insulating layer (61) and a passivation layer (69). The metal layer (58) extends on the surface (53a) of the semiconductor body (53); the first insulating layer (61) extends in part above the metal layer (58) and in part above the surface (53a) of the semiconductor body (53); the interface layer (63) extends above the first insulating layer (61) and in part above the metal layer (58), wherein the interface layer (63) directly contacts the metal layer (58) and the surface (53a) of the semiconductor body (53); the passivation layer (69) extends in part on the metal layer (58), in part on the surface (53a) and completely covers the interface layer (63). The first insulating layer (61) is of a first electrically insulating material; the interface layer (63) is of a second electrically insulating material and the passivation layer (69) is of a third electrically insulating material.

## Description

The present invention relates to a SiC-based electronic device with enhanced robustness and to a method for manufacturing the electronic device.

Silicon carbide (SiC) is gaining considerable interest in the semiconductor industry, in particular for the manufacture of electronic components such as diodes or transistors, especially for power applications.

Electronic devices formed in a substrate of silicon carbide, in its different polytypes (for example, 3C-SiC, 4H-SiC, 6H-SiC), have numerous advantages such as low output resistance in conduction, low leakage current, resistance at high operating temperatures and high operating frequencies.

Generally, in these devices, the substrate is covered by one or more passivation layers using polymeric materials (for example, polymide) which provide protection against the external environment, in particular by preventing humidity from entering the device, and allow high operating temperatures of electronic devices to be withstood. They also have high dielectric strength, for example greater than 400 kV/mm. In detail, the high dielectric strength of polymeric materials ensures that the passivation layers withstand high electric fields and therefore high potential differences thereacross, without undergoing breakage or perforation.

However, polymeric materials have high coefficients of thermal expansion (CTE) (for example, CTE=43e⁻⁶ 1/K for the polybenzobisoxazole material, or "PIX"), and this causes adhesion issues of the passivation layer to SiC, which has a lower coefficient of thermal expansion (CTE=3.8e⁻⁶ 1/K).

In particular, such adhesion issues between the passivation layer and the SiC may arise during thermal cycling tests, performed for example between about -50°C and about +150°C, or while using the electronic device, when the latter is subject to high thermal excursions (for example, it is subject to operating temperature differences equal to, or greater than, about 200°C). Due to the high difference in CTE between the passivation layer and the SiC, such high thermal excursions may generate mechanical stresses at an interface between the passivation layer and the SiC, which may lead to an at least partial delamination of the passivation layer with respect to the SiC semiconductor body.

If this delamination is extended (for example, it is such as to expose to the air two metallizations of the electronic device set at different potentials), electric discharges may generate at the interface, leading to the damage of the same electronic device. In particular, the risk of damaging the electronic device increases when the latter is used in reverse bias conditions, due to the high voltage difference (for example, greater than 1000 V) to withstand.

Known solutions to this issue comprise the use of a plurality of dielectric layers of different materials (for example, silicon nitride, silicon oxide and polymide in succession to each other) to form a passivation multilayer for limiting the mechanical stresses at the interface with the SiC semiconductor body.

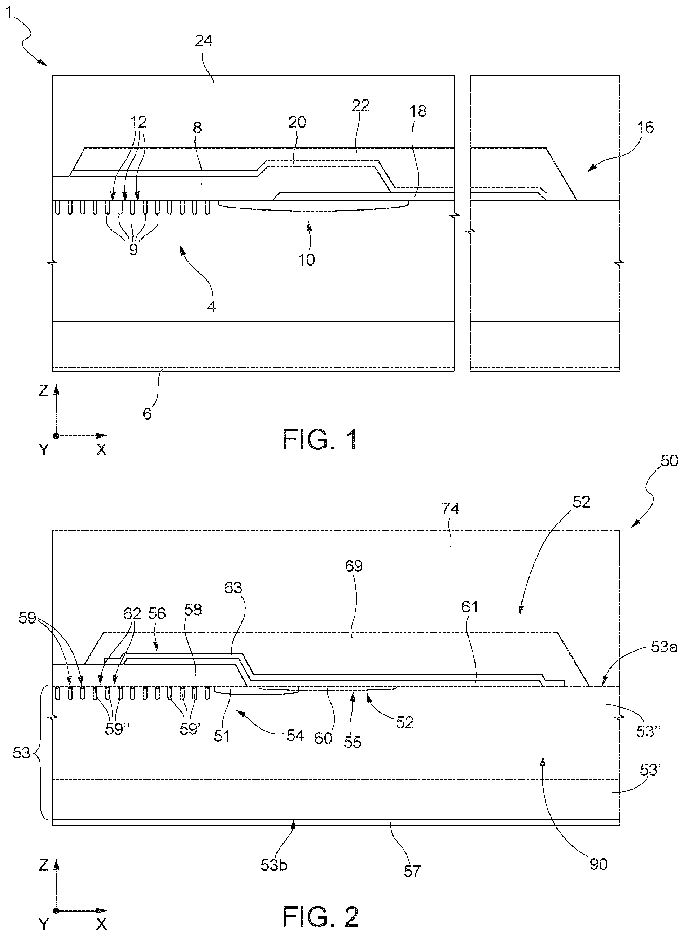

Figure 1 shows, in a lateral sectional view in a Cartesian (triaxial) reference system of axes X, Y, Z, a portion of an electronic device (here exemplarily a JBS, "Junction Barrier Schottky", diode) 1 of a known type.

The JBS device 1 comprises a semiconductor body 3, of N-type SiC, having an upper surface 3a and a lower surface 3b. The semiconductor body 3 includes, for example, a substrate and one or more regions that are epitaxially grown on the substrate, of N-type and have respective doping concentration values.

The JBS device 1 also comprises multiple junction-barrier elements 9 (hereinafter also referred to as JB, Junction-Barrier, elements 9) in the semiconductor body 3, facing the upper surface 3a and each including a respective region implanted in the semiconductor body 3, of P-type, and an ohmic contact (not shown) on the implanted region, at the upper surface 3a of the semiconductor body 3.

The JBS device 1 further comprises a first metallization 8, which extends on the upper surface 3a, in electrical contact with the JB elements 9 through the respective ohmic contacts (not shown).

The JBS device 1 further comprises an edge termination region 10 (or protection ring), in particular a P-type implanted region, which completely surrounds the JB elements 9.

Schottky diodes 12 are formed at the interface between the first metallization 8 and the semiconductor body 3, where semiconductor-metal Schottky junctions are formed. The region of the JBS device 1 that includes the JB elements 9 and the Schottky diodes 12 (i.e., the region contained within the protection ring 10) is an active area 4 of the JBS device 1.

The JBS device 1 further comprises a second metallization 6, which extends on the lower surface 3b. The first and the second metallizations 8, 6 form, respectively, anode and cathode electrical terminals, biasable during use of the JBS device 1.

An electrically passive region 16 extends externally to the edge termination region 10.

An insulating layer 18, in particular silicon oxide (SiO₂), extends partially above the edge termination region 10.

The first metallization 8 is in electrical contact with a portion of the edge termination region 10, where the latter is not covered by the insulating layer 18, and also extends partially above the insulating layer 18.

An interface layer 20, here of silicon nitride (SiN), extends above the first metallization 8 and the insulating layer 18.

Furthermore, the JBS device 1 comprises a passivation layer 22, in particular of polymide, which extends above the interface layer 20. In other words, the interface layer 20 acts as an interface between the passivation layer 22 and the underlying layers, here the first metallization 8 and the insulating layer 18.

A protection layer 24, of a resin such as for example bakelite, extends here above the passivation layer 22, to protect the JBS device 1 and forms a package.

However, although the interface layer 20 improves, as mentioned, the adhesion of the passivation layer 22 to the underlying layers, some critical conditions of use or thermal or thermo-mechanical test of the JBS device 1 may cause a delamination or partial detachment of the passivation layer 22 from the interface layer 20 due to the generated stress. This occurs, in particular, in presence of high use temperatures (for example, above 150°C). This effect, in addition to making the JBS device 1 structurally fragile, may facilitate the onset of unwanted electric discharges which do not allow the JBS device 1 to operate correctly or completely compromise its functioning. In fact, the Applicant has verified that in some thermo-mechanical or mechanical stress conditions following the assembling process, the interface layer 20 has one or more local cracks throughout the entire thickness which, at the first metallization 8, cause the generation of electric discharges. This issue occurs, in particular, when the JBS device 1 is subject to high thermal excursions and high voltage differences in reverse bias conditions.

The need to overcome the aforementioned issues is therefore felt.

Devices of this type are described for example in documents US 2023/170390 A1 and US 2024/178092 A1.

According to the present invention, a SiC-based electronic device and a manufacturing method thereof are provided, as defined in the attached claims.

For a better understanding of the present invention, embodiments are now described, purely by way of non-limiting example, with reference to the attached drawings, wherein:
- Figure 1 illustrates, in cross-sectional view, an electronic device of a known type;
- Figure 2 illustrates, in cross-sectional view, an electronic device according to one embodiment;
- Figures 3A-3D show, in cross-sectional view, manufacturing steps of the electronic device of Figure 2, according to an embodiment;
- Figure 4 illustrates, in cross-sectional view, an electronic device according to a further embodiment; and
- Figures 5A-5D show, in cross-sectional view, manufacturing steps of the electronic device of Figure 4, according to an embodiment.

Figure 2 shows an electronic device 50. In particular, the device 50 is a JBS diode, however, the present description is not limited to this device and also finds application to other types of electronic devices, in particular power devices, such as for example, MOSFET, IGBT, MPS, Schottky diode, PN diode, PiN diode, etc.

In particular, Figure 2 shows an end portion of the electronic device 50 arranged peripherally to a die 90 of semiconductor material where the same electronic device 50 is integrated.

The device 50 comprises a semiconductor body 53, having a front surface 53a and a rear surface 53b. In particular, in Figure 2, the semiconductor body 53 includes a substrate 53' and, optionally, one or more epitaxial layers 53" grown thereon and operating as a drift layer of the electronic device 50. Hereinafter, reference will be made to a single epitaxial layer 53", but what is indicated also applies in the case of multiple epitaxial layers.

The semiconductor body 53 is of N-type or P-type silicon carbide (SiC) (hereinafter non-limiting reference will be made to only N-type). In particular, the semiconductor body 53 is of 4H-SiC type, however other polytypes may be used, such as 2H-SiC, 3C-SiC and 6H-SiC. For example, the substrate 53' has an N-type dopant concentration comprised between 1.10¹⁹ at/cm³ and 1.10²² at/cm³ and has a thickness, measured between the surfaces 53a and 53b (along a vertical axis Z of a Cartesian reference system XYZ), comprised between 300 µm and 450 µm and in particular equal to about 360 µm. The epitaxial layer 53" has a respective dopant concentration lower than the dopant concentration of the substrate 53' and a thickness comprised, for example, between 5 and 15 µm.

A metallization 57, in this example a cathode metallization 57, for example of Ti/NiV/Ag or Ti/NiV/Au, extends on the rear surface 53b. An ohmic contact layer not shown (for example of nickel silicide) may extend between the substrate 53' and the metallization 57, on the rear surface 53b.

One or more barrier doped regions 59', here of P-type, extend in the semiconductor body 53 (in particular in the epitaxial layer 53"), starting from the front surface 53a, at a mutual distance along the X axis.

The barrier doped regions 59' may have a width, along the X axis, comprised for example between 0.5 and 10 µm.

In this embodiment, the electronic device 50 comprises, optionally, for each barrier doped region 59', also a respective ohmic contact region 59", accommodated in the barrier doped region 59' at the front surface 53a.

Each barrier doped region 59' and the respective ohmic contact region 59" form a junction-barrier element 59, hereinafter also referred to as JB (Junction-Barrier) element 59.

The electronic device 50 comprises an edge structure 52 which extends perimetrically and annularly with respect to the die 90 and of which Figure 2 shows only a portion, in cross-section.

In particular, the edge structure 52 extends above an edge zone 55 of the semiconductor body 53.

The edge structure 52 here comprises a terminal anode region 51, extending in epitaxial layer 53" around the zone thereof accommodating the JB elements 59.

The edge structure 52 further comprises an edge termination region, or protection ring, 60.

The edge termination region 60 is formed by a further doped region, here of P-type, extending in the epitaxial layer 53", facing the front surface 53a and completely surrounding the JB elements 59 in plan-view, on an XY plane defined by horizontal axes X and Y of the Cartesian coordinate system XYZ. The edge termination region 60 surrounds and delimits an active area 54 and may be partially superimposed on the terminal anode region 51.

However, the edge termination region 60 is not essential and may be omitted.

The edge structure 52 also comprises part of a metallization 58, in this example an anode metallization 58, for example of Ti/AlSiCu or Ni/AlSiCu, extending on a portion of the front surface 53a, at the active area 54.

One or more Schottky diodes 62 are formed at the interface between the semiconductor body 53 and the anode metallization 58, laterally and between the barrier doped regions 59'. In particular, Schottky diodes are formed by semiconductor-metal junctions formed by the portions of the semiconductor layer 53 in direct contact with the anode metallization 58.

Furthermore, each ohmic contact region 59", above the respective barrier doped region 59', forms an electrical connection region between the anode metallization 58 and the respective barrier doped region 59'; this electrical connection region has a lower resistivity value than the respective same barrier doped region 59'. The JB elements 59 are therefore P-i-N diodes.

The edge structure 52 further comprises an insulating layer 61, an interface layer 63 and a passivation layer 69.

The insulating layer 61, in particular of dielectric or insulating material (such as for example silicon oxide or TEOS - tetraethyl orthosilicate), extends in part above the anode metallization 58 and in part above the front surface 53a.

In particular, the anode metallization 58 comprises an external portion 56 and the insulating layer 61 seals the external portion 56 at an end portion of the electronic device 50.

For example, the insulating layer 61 has a thickness, along the vertical axis Z, comprised between 0.2 and 2 µm.

The interface layer 63, here of silicon nitride (SiN), extends, seamlessly, in part above the insulating layer 61 and in part on the anode metallization 58, as well as partially on the front surface 53a, alongside the external peripheral edge of the insulating layer 61.

In other words, as shown in Figures 2-5D, the interface layer 63 directly contacts the anode metallization 58 and the surface 53a of the semiconductor body 53.

For example, the interface layer 63 has a thickness, along the vertical axis Z, comprised between 0.2 and 2 µm.

The passivation layer 69 is of organic material, in particular polymeric material such as polymide (for example, PIX), completely covers the interface layer 63 and also extends on the anode metallization 58 and in part on the front surface 53a, alongside the internal and external edges of the interface layer 63.

In practice, the interface layer 63 extends between the passivation layer 69 and the underlying layers, here the insulating layer 61, and helps adhesion of the overlying passivation layer 69.

A protection layer 74, of a resin such as for example bakelite, extends above the passivation layer 69, for packaging the electronic device 50.

In this manner, the edge structure 52 of the electronic device 50 comprises a triple layer (the insulating layer 61, the interface layer 63 and the passivation layer 69) which protects the electronic device 50 from the external environment and, in particular, prevents humidity from reaching high-voltage structures and metallizations (for example the anode metallization 58).

In particular, here, the insulating layer 61 encloses and seals the periphery of the anode metallization 58; the interface layer 63 encloses and seals the insulating layer 61 both at the top and on its lateral edges; and the passivation layer 69 encloses and seals the interface layer 63 both at the top and on its lateral edges.

The edge structure 52 therefore has a package configuration wherein each layer covers and seals the underlying layer, ensuring high robustness even in case of numerous thermal cycles and/or hostile environmental conditions.

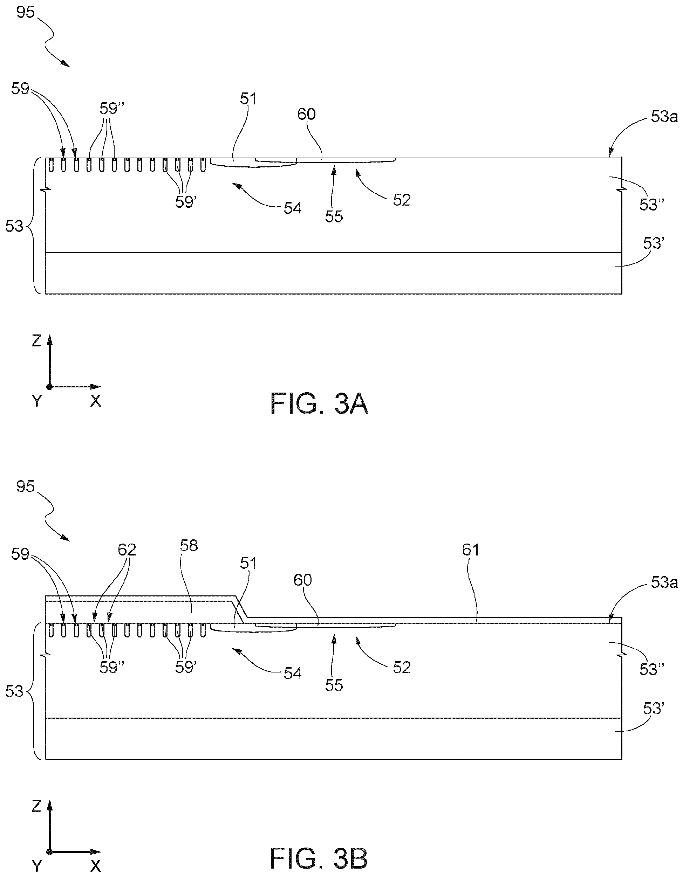

Manufacturing steps of the electronic device 50 of Figure 2 are described hereinbelow with reference to Figures 3A-3D and limitedly to manufacturing steps useful for understanding the present disclosure. Figures 3A-3D are represented in the same reference system XYZ as Figure 2.

With reference to Figure 3A, a wafer 95 has initially been processed so as to form, in the semiconductor body 53 of SiC and in a per se known manner, the JB elements 59, the terminal anode region 51 and the edge termination region 60.

With reference to Figure 3B, the anode metallization 58 is formed, for example by evaporation or "sputtering" and subsequent lithographic definition and etching of the deposited metal layer. The anode metallization 58 may comprise one or more layers, for example a layer of titanium or nickel and a thick layer of an Al-based alloy, such as AlSiCu, AlCu, Al.

Subsequently, insulating or dielectric material is deposited to form the insulating layer 61. This step is performed for example by a CVD (Chemical Vapor Deposition) or LPCVD (Low Pressure Chemical Vapor Deposition) process wherein the insulating or dielectric material is deposited on the entire upper surface of the wafer (indicated again by 53a) and then selectively removed through phototechnique and etching, so as to completely cover the external edge of the anode metallization 58.

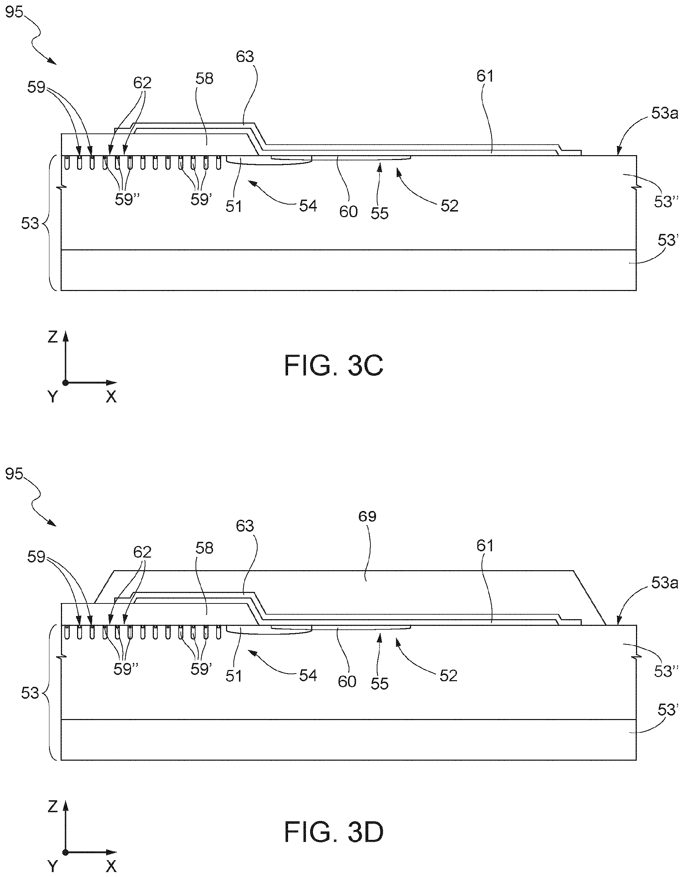

Then, Figure 3C, the interface layer 63 is formed, for example by CVD deposition of silicon nitride and definition, through phototechnique and etching, of the deposited layer, so that the interface layer 63 encloses and seals the insulating layer 61. The interface layer 63 also extends, in part, both on the surface of the anode metallization 58 and on the front surface 53a of the semiconductor body 53.

Then, Figure 3D, the passivation layer 69 is formed. This step comprises a deposition of insulating material, for example polymide, with a deposition process such as spinning, subsequent definition and "curing" treatment.

The passivation layer 69 therefore completely covers the interface layer 63, enclosing and sealing it with respect to the outside, and extends in part above the anode metallization 58 and the front surface 53a.

In particular, the passivation layer 69 leaves uncovered the zones that need to be made accessible from the outside, for example the central zone of the anode metallization 58, to allow the electrical contact thereof.

The manufacturing process then continues with known subsequent steps to form further elements of the electronic device 50, here not described in detail (for example, to form an ohmic contact layer not shown (if any) and the cathode metallization 57) and for dicing the wafer 95 into single dice.

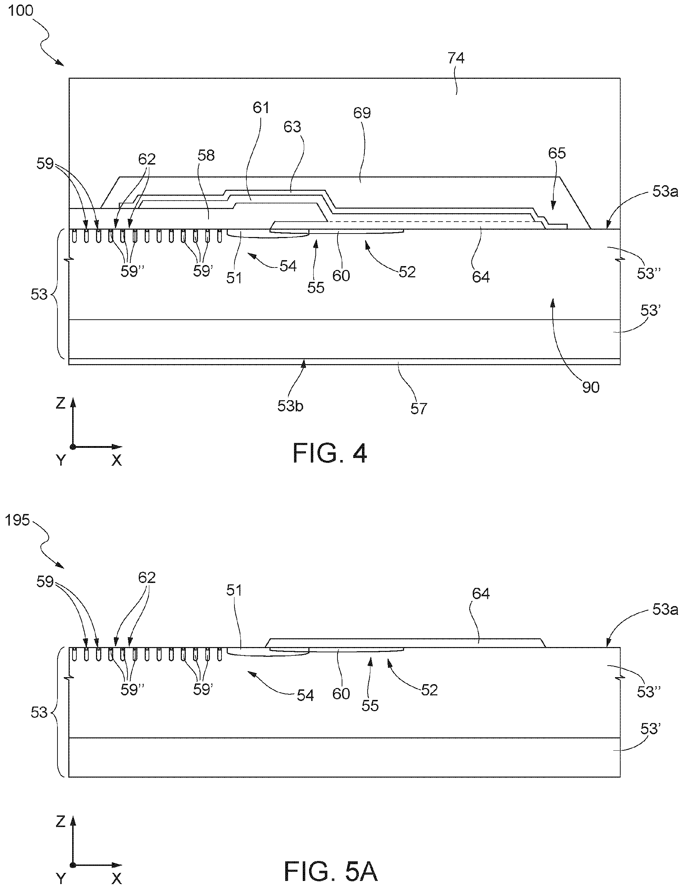

Figure 4 illustrates an electronic device 100 according to a further embodiment. The electronic device 100 is represented in the same Cartesian (triaxial) reference system XYZ, as in Figure 2.

In particular, the electronic device 100 is a JBS diode, in analogy to what has been described with reference to Figures 1 and 2; however, even in this case, the present invention is not limited to a JBS device and also finds application in other types of electronic devices, in particular power devices, such as for example MOSFET, IGBT, MPS, Schottky diode, PN diode, PiN diode, etc.

Elements of the electronic device 100 common to the electronic device 50 of Figure 2 are indicated with the same reference numbers and are not further described.

The edge structure 52 comprises a further insulating layer 64 of a dielectric or insulating material (such as for example silicon oxide or TEOS - tetraethyl orthosilicate).

The further insulating layer 64 extends on the front surface 53a of the semiconductor body 53, partially below the insulating layer 61 (therefore herein also referred to as first insulating layer 61) and the anode metallization 58.

Since the further insulating layer 64 may be of the same material as the first insulating layer 61, it may be indistinguishable from the latter in the superimposition zone; the border between the two insulating layers 61 and 64 is therefore indicated with a dashed line in Figure 4.

Here, the interface layer 63 also covers the external lateral portion 65 of the further insulating layer 64.

The anode metallization 58 extends on the internal edge of the further insulating layer 64.

Therefore, the interface layer 63, also here of silicon nitride (SiN), extends alongside and seals both the external peripheral edge of the first insulating layer 61 and the external peripheral edge of the further insulating layer 64.

The further insulating layer 64, for example, has a thickness, along the vertical axis Z, comprised between 0.5 and 2 µm.

The passivation layer 69 of polymeric material such as polymide (for example, PIX) completely covers the interface layer 63 and further extends on the anode metallization 58 and in part on the front surface 53a, alongside the internal and external edges of the interface layer 63.

Manufacturing steps of the electronic device 100 of Figure 4 are described hereinbelow with reference to Figures 5A-5D and limitedly to manufacturing steps useful for understanding the present disclosure.

With reference to Figure 5A, a wafer 195 has been initially processed so as to form, in the semiconductor body 53 of SiC and in a per se known manner, the JB elements 59, the terminal anode region 51 and the edge termination region 60.

Here, insulating or dielectric material is deposited on the front surface 53a to form the further insulating layer 64 so as to form, in the semiconductor body 53 of SiC and in a per se known manner, an active area 54.

The step of forming the further insulating layer 64 is performed for example by a CVD (Chemical Vapor Deposition) or LPCVD (Low Pressure Chemical Vapor Deposition) process wherein the insulating or dielectric material is deposited on the entire upper surface 53a of the wafer 195 and then selectively removed by phototechnique and etching, so as to completely cover the edge termination region 60 and partially cover the terminal anode region 51.

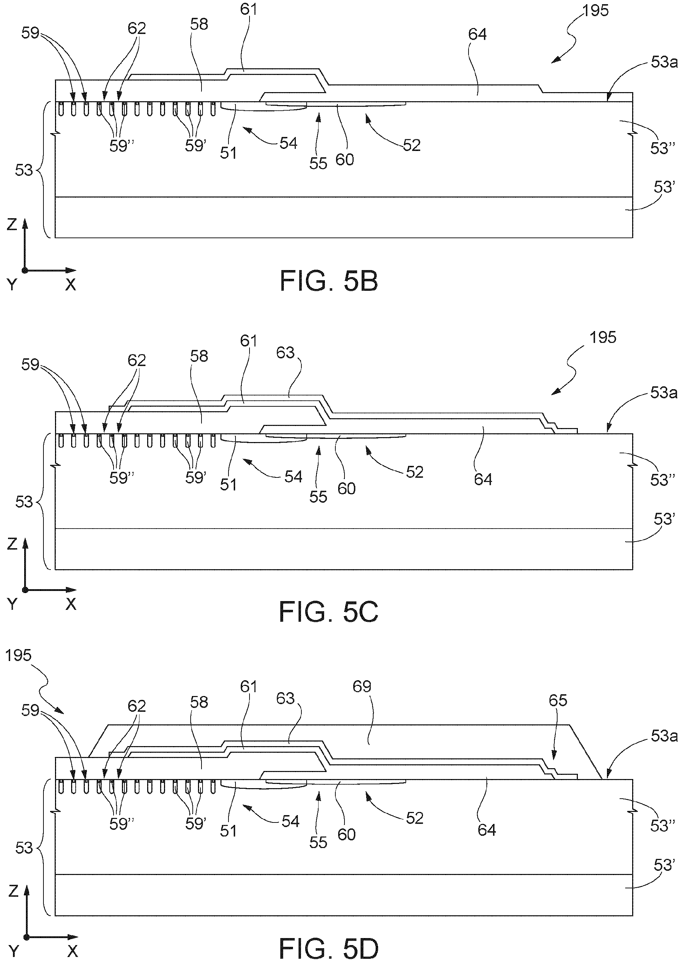

With reference to Figure 5B, the anode metallization 58 is then formed, for example by "sputtering" and subsequent lithographic definition and etching of the deposited metal layer. Subsequently, insulating or dielectric material is deposited to form the first insulating layer 61 by the processes described above, so as to completely cover and seal the external edge of the anode metallization 58.

Then, Figure 5C, the interface layer 63 is formed, for example by the above-mentioned processes, so that the interface layer 63 encloses and seals the insulating layer 61 and the further insulating layer 64 and also extends, in part, both on the surface of the anode metallization 58 and on the front surface 53a of the semiconductor body 53.

Then, Figure 5D, the passivation layer 69 is formed. This step comprises for example a deposition of insulating material, such as polymide, by spinning, a subsequent definition and a curing treatment.

The passivation layer 69 therefore completely covers the interface layer 63, enclosing and sealing it from the outside, and extends in part above the anode metallization 58 and the front surface 53a.

Also here, the passivation layer 69 leaves uncovered the zones that need to be made accessible from the outside, for example the central zone of the anode metallization 58.

The manufacturing process then continues with subsequent steps to form the further elements of the electronic device 100, here not described in detail (for example, to form the ohmic contact layer - not shown - if any, and the cathode metallization 57) and for dicing the wafer 195 to form the electronic device 100.

The electronic device described and the manufacturing process thereof have numerous advantages.

Firstly, the edge structure 52 comprises a triple layer (the first insulating layer 61, the interface layer 63 and the passivation layer 69) which protects the electronic device 50, 100 from the external environment and prevents, in particular, humidity from reaching high-voltage structures and metallizations.

Furthermore, the passivation layer 69 extends above the interface layer 63 and the front surface 53a, thereby protecting the edge structure; this is therefore particularly robust and reliable during thermal stress tests of the electronic device 50, 100. Furthermore, the passivation layer 69 reduces the propagation of stresses that cause the interface layer 63 to break.

In other words, the edge structure 52 ensures high electrical performances of the electronic device 50, 100 and eliminates, at the same time, structural issues linked to the possible breakage of the interface layer 63 following thermal cycles or use of the electronic device 50, 100.

Finally, it is clear that modifications and variations may be made to the electronic device and manufacturing process thereof described and illustrated herein without thereby departing from the scope of the present invention, as defined in the attached claims.

## Claims

1. An electronic device (50; 100), comprising:
a semiconductor body (53) of silicon carbide having a surface (53a) and an edge zone (55); and
an edge structure (52) extending above the edge zone (55) of the semiconductor body (53), the edge structure (52) including:
a metal layer (58) extending on the surface (53a) of the semiconductor body (53);
a first insulating layer (61) extending in part above the metal layer (58) and in part above the surface (53a) of the semiconductor body (53), of a first electrically insulating material;
an interface layer (63) extending above the first insulating layer (61) and in part above the metal layer (58), the interface layer (63) of a second electrically insulating material, different from the first electrically insulating material; wherein the interface layer (63) directly contacts the metal layer (58) and the surface (53a) of the semiconductor body (53); and
a passivation layer (69) extending in part on the metal layer (58), in part on the surface (53a) and completely covering the interface layer (63), the passivation layer (69) of a third electrically insulating material different from the second electrically insulating material.

2. The electronic device according to claim 1, wherein the interface layer (63) has a first and a second end portion and the passivation layer (69) completely covers and seals the first and the second end portions of the interface layer (63), directly contacting the metal layer (58) and the surface (53a) of the semiconductor body (53) alongside the first and the second end portions of the interface layer (63).

3. The electronic device according to the preceding claim, wherein the first insulating layer (61) has a first end portion and a second end portion and the interface layer (63) completely covers and seals the first and the second end portions of the first insulating layer (61) alongside the first and the second end portions of the first insulating layer (61).

4. The electronic device according to the preceding claim, wherein the metal layer (58) has an external portion (56) and the first insulating layer (61) covers and seals the external portion (56) of the metal layer (58).

5. The electronic device according to claim 3 or 4, further comprising a second insulating layer (64) extending on the surface (53a) of the semiconductor body (53), partially below the first insulating layer (61) and the metal layer (58), wherein the second end portion of the first insulating layer (61) is superimposed on an external lateral portion (65) of the second insulating layer (64) and the interface layer (63) further covers the external lateral portion (65) of the second insulating layer (64).

6. The electronic device according to any of the preceding claims, wherein the first electrically insulating material is silicon oxide or TEOS.

7. The electronic device according to any of the preceding claims, wherein the second electrically insulating material is silicon nitride.

8. The electronic device according to any of the preceding claims, wherein the third electrically insulating material is polymide.

9. The electronic device according to claim 5 or one or more of claims 6-8 when depending on claim 5, wherein the second insulating layer (64) is silicon oxide or TEOS.

10. A method for manufacturing an electronic device (50; 100), comprising forming an edge structure (52) on a semiconductor body (53) of silicon carbide having a surface (53a) and an edge zone (55),
wherein forming an edge structure (52) comprises:
forming a metal layer (58) on the surface (53a) of the semiconductor body (53);
forming, in part on the surface (53a) of the semiconductor body (53) and in part on the metal layer (58), a first insulating layer (61) of a first electrically insulating material;
forming, on the first insulating layer (61) and in part on the metal layer (58), an interface layer (63) of a second electrically insulating material, different from the first electrically insulating material;
wherein the interface layer (63) directly contacts the metal layer (58) and the surface (53a) of the semiconductor body (53); and
forming, on the interface layer (63), in part on the metal layer (58) and in part on the first surface (53a) of the semiconductor body (53), a passivation layer (69) of a third electrically insulating material different from the second electrically insulating material, the passivation layer (69) completely covering the interface layer (63).

11. The manufacturing method according to the preceding claim, wherein forming the interface layer (63) comprises forming a first and a second end portion and forming the passivation layer (69) comprises completely covering and sealing the first and the second end portions of the interface layer (63), directly contacting the metal layer (58) and the surface (53a) of the semiconductor body (53) alongside the first and the second end portions of the interface layer (63).

12. The manufacturing method according to the preceding claim, wherein forming the first insulating layer (61) comprises forming a first end portion and a second end portion and wherein forming the interface layer (63) comprises completely covering and sealing the first and the second end portions of the first insulating layer (61), directly contacting the metal layer (58) and the surface (53a) of the semiconductor body (53) alongside the first and the second end portions of the first insulating layer (61).

13. The manufacturing method according to the preceding claim, wherein forming the metal layer (58) comprises forming an external portion (56) and wherein forming the first insulating layer (61) comprises covering and sealing the external portion (56) of the metal layer (58).

14. The manufacturing method according to any of claims 10-13, further comprising forming a second insulating layer (64) on the surface (53a) of the semiconductor body (53), partially below the first insulating layer (61) and the metal layer (58) and wherein forming the interface layer (63) comprises covering an external lateral portion (65) of the second insulating layer (64).

15. The manufacturing method according to claim 14, wherein the second insulating layer (64) surrounds an active area (54) and the metal layer (58) is superimposed and in direct electrical contact with the surface (53a) of the semiconductor body at the active area (54).
